(19) **Europäisches Patentamt / European Patent Office / Office européen des brevets**

(11) **EP 4 780 173 A1**

(12) **EUROPEAN PATENT APPLICATION**
published in accordance with Art. 153(4) EPC

(43) Date of publication:
**22.07.2026 Bulletin 2026/30**

(51) International Patent Classification (IPC):
**H10H 20/80** $^{(2025.01)}$

(21) Application number: **24865522.7**

(22) Date of filing: **12.09.2024**

(86) International application number:
**PCT/JP2024/032720**

(87) International publication number:
**WO 2025/058022 (20.03.2025 Gazette 2025/12)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **15.09.2023 JP 2023149758**

(71) Applicants:
- **RIKEN**
  **Wako-shi, Saitama 351-0198 (JP)**
- **Shibaura Machine Co., Ltd.**
  **Tokyo 100-0011 (JP)**
- **Dai Nippon Printing Co., Ltd.**
  **Tokyo 162-8001 (JP)**
- **ULVAC, Inc.**
  **Chigasaki-shi, Kanagawa 253-8543 (JP)**
- **SHIN-ETSU CHEMICAL CO., LTD.**
  **Tokyo 100-0005 (JP)**

(72) Inventors:
- **HIRAYAMA, Hideki**
  **Wako-shi, Saitama 351-0198 (JP)**
- **KASHIMA, Yukio**
  **Wako-shi, Saitama 351-0198 (JP)**
- **MATSUURA, Eriko**
  **Wako-shi, Saitama 351-0198 (JP)**
- **NAGANO, Tsugumi**
  **Tokyo 162-8001 (JP)**
- **KAMIMURA, Ryuichiro**
  **Chigasaki-shi, Kanagawa 253-8543 (JP)**
- **OSADA, Yamato**
  **Chigasaki-shi, Kanagawa 253-8543 (JP)**
- **ENDO, Ryuta**
  **Chigasaki-shi, Kanagawa 253-8543 (JP)**
- **KOKUBO, Mitsunori**
  **Tokyo 100-0011 (JP)**
- **SHINOHARA, Hidetoshi**
  **Gotemba-shi, Shizuoka 412-0038 (JP)**
- **YAMADA, Masato**
  **Tokyo 100-0005 (JP)**
- **KAWAHARA, Minoru**
  **Tokyo 100-0005 (JP)**

(74) Representative: **Gleiss Große Schrell und Partner mbB**
**Leitzstraße 45**
**70469 Stuttgart (DE)**

(54) **ALGAN-BASED DEEP ULTRAVIOLET LED AND METHOD FOR MANUFACTURING THE SAME**

(57) The light extraction efficiency (LEE) of a UVC-LED in a 230 nm band is improved. An AlGaN-based deep ultraviolet LED having a wavelength $\lambda$ of emission light includes a photonic crystal periodic structure in a thickness direction, in which a distance between an upper part of a quantum well layer and a bottom part of the photonic crystal periodic structure substantially satisfies a resonance condition $\lambda/n$ of free-end reflection, where n is a weighted average refractive index of a layer structure existing between the upper part of the quantum well layer and the bottom part of the photonic crystal periodic structure.

**EP 4 780 173 A1**

# Fig. 1

(a)

(b)

1. Au electrode layer
2. Ni electrode layer
3. p-type GaN contact layer
4. p-type AlGaN layer
5. Electron block layer (AlN-EBL)
6. Spacer layer (AlGaN-spacer)
7. Multiple quantum well layer (MQW) (well layer/barrier layer) 4pair

8. n-type AlGaN layer
9. AlN layer
10. Sapphire substrate
100. Photonic crystal periodic structure
101. Void (hole)

**Description**

Technical Field

The present invention relates to an AlGaN-based deep ultraviolet LED and a method for manufacturing the same.

Background Art

Deep ultraviolet LEDs (UVC-LEDs) with an emission wavelength in a 230 nm band have been attracting attention in terms of surface sterilization that is harmless to a human body when irradiated. Regarding the performance of the UVC-LEDs in the 230 nm band, when the Al composition exceeds 80%, the TM light increases to cause lateral light emission and the TE light is absorbed and lost in a p-type GaN contact layer, thereby reducing the light extraction efficiency (LEE) as compared to UVC-LEDs in a 280 nm, and as a result, the external quantum efficiency (EQE) is 1% or less.

According to Patent Literature 1, a photonic crystal (PhC) is formed in a thickness direction including an interface between a p-type GaN contact layer and a p-type AlGaN layer thereby reflecting light so that the aforementioned absorption is suppressed, and as a result, a maximum enhancement factor of 2.76 of the LEE in an emission wavelength of 280 nm, a 16.6% LEE is obtained in a structure having the photonic crystal formed therein as compared to a 6% LEE in a structure without the photonic crystal. Note that the ratio of TE light to TM light in the 280 nm is 7:3.

Citation List

Patent Literature

Patent Literature 1: JP 6156898 B1

Non Patent Literature

Non Patent Literature 1: Applied Physics Express 14, 084004 (2021)

Summary of Invention

Technical Problem

However, the photonic crystal of Patent Literature 1 can achieve a nearly 100% reflection effect for TE light, but cannot obtain the reflection effect for TM light. Further, as the light emission wavelength is reduced to 230 nm or less, the ratio of TM light increases and the LEE decreases. In addition, Non-Patent Literature 1 forms a highly reflective Rh on a p-electrode, reduces the film thickness of a p-type GaN contact layer having high optical absorption, and precisely controls the film thickness of a p-type AlGaN layer, so as to utilize a fixed-end reflection effect of reversing the phase between the incident waves and the reflected waves, thereby improving the LEE by 1.5 times or more.

An object of the present invention is to provide a novel technique for increasing the LEE of a UVC-LED in a 230 nm band.

Solution to Problem

An example of an AlGaN-based deep ultraviolet LED having a wavelength $\lambda$ of emission light according to the present invention includes a photonic crystal periodic structure in a thickness direction, in which a distance between an upper part of a quantum well layer and a bottom part of the photonic crystal periodic structure substantially satisfies a resonance condition $\lambda/n$ of free-end reflection, where n is a weighted average refractive index of a layer structure existing between the upper part of the quantum well layer and the bottom part of the photonic crystal periodic structure.

In the example, a period a of the photonic crystal periodic structure relative to light having the wavelength $\lambda$ satisfies a Bragg condition of $a = (m/2) \times \lambda/n_{Phc}$, where $m \leq 4$ and $n_{Phc}$ is an effective refractive index of the photonic crystal periodic structure.

In the example, the photonic crystal periodic structure includes a plurality of holes formed in an area in a thickness direction from a lower part of a p-type electrode layer to an interface between a p-type GaN contact layer and a p-type AlGaN layer.

In the example, when a radius of each of the holes is R and a period of the photonic crystal periodic structure is a, $0.35 \leq R/a$ is satisfied.

In the example, the photonic crystal periodic structure includes a photonic band gap that is open to a TE polarized light component.

In the example, an Au electrode layer; a Ni electrode layer; a p-type GaN contact layer; a p-type AlGaN layer transparent to the wavelength λ; an electron block layer transparent to the wavelength λ; a spacer layer transparent to the wavelength λ; a multiple quantum well layer transparent to the wavelength λ; and an n-type AlGaN layer transparent to the wavelength λ are included sequentially from a side opposite to a substrate.

The distance between the upper part of the quantum well layer and the bottom part of the photonic crystal periodic structure falls within a range of (λ/n) ± 5 nm.

An example of a method for manufacturing the aforementioned AlGaN-based deep ultraviolet LED includes the steps of: forming a pattern of the photonic crystal periodic structure, in a two-layer resist composed of an upper layer and a lower layer using nanoimprint lithography; forming the photonic crystal periodic structure in the p-type GaN contact layer by ICP dry etching; separating an n-electrode part and a p-electrode part by p-mesa processing to expose a part of the n-type AlGaN layer; forming an n-electrode by evaporating vanadium (V), aluminum (Al), titanium (Ti), and gold (Au) on a surface of the exposed part of the n-type AlGaN layer; and forming a p-electrode by obliquely evaporating nickel (Ni) and gold (Au) on a surface of the p-type GaN contact layer.

Advantageous Effects of Invention

According to the present invention, by forming a photonic crystal periodic structure that satisfies a resonance condition of free-end reflection, the LEE of a UVC-LED can be dramatically improved.

Brief Description of Drawings

Figs. 1 are the structure (cross-sectional view and plan view) of a UVC-LED having a light emission wavelength λ of 230 nm according to a first embodiment.

Fig. 2 is a STEM cross-sectional image of a p-type GaN contact layer/p-type AlGaN layer (having a film thickness of 65 nm as a typical example).

Fig. 3 is a STEM cross-sectional image of a multi-quantum well layer/spacer layer (AlGaN-spacer)/electron block layer (AlN-EBL).

Figs. 4 are a SEM top-view and a SEM cross-sectional image in which a PhC pattern is transferred to a surface of the p-type GaN contact layer using a nanoimprint method.

Figs. 5 are SEM cross-sectional images in which processing of a PhC with a depth of 95 nm and with a depth of 100 nm was performed in accordance with a PhC pattern using an ICP dry etching method.

Figs. 6 are SEM cross-sectional images of examples of a PhC with a depth of 95 nm and with a depth of 100 nm on which p-mesa processing for electrode processing was performed by ICP dry etching.

Fig. 7 is a STEM cross-sectional image of a reference structure in which Ni (80 nm)/Au (50 nm) was obliquely evaporated on a PhC formed in the p-type GaN contact layer.

Figs. 8 are graphs showing current-power characteristics and current-EQE characteristics of examples including the p-type AlGaN with a film thickness of 65 nm and having no-PhC and having a PhC with a depth of 95 nm.

Figs. 9 are graphs showing examples having no-PhC, a PhC with a depth of 95 nm, and a PhC with a depth of 100 nm, by representing the film thickness of the p-type AlGaN on the horizontal axis, and the output (power) and enhancement factor at a drive current ($I_F$) of 100 mA on the vertical axis.

Figs. 10 are SEM cross-sectional images of a reference structure having a PhC with a depth of 95 nm and a reference structure having a PhC with a depth of 100 nm that are formed in the p-type GaN contact layer.

Figs. 11 are graphs showing the distance between a quantum well layer and a PhC on the horizontal axis, and the output (power) and enhancement factor on the vertical axis.

Description of Embodiments

Hereinafter, a deep ultraviolet LED (hereinafter, occasionally referred to as a "UVC-LED") according to an embodiment of the present invention will be described in detail with reference to the drawings. This UVC-LED is an AlGaN-based deep ultraviolet LED having a light emission wavelength λ.

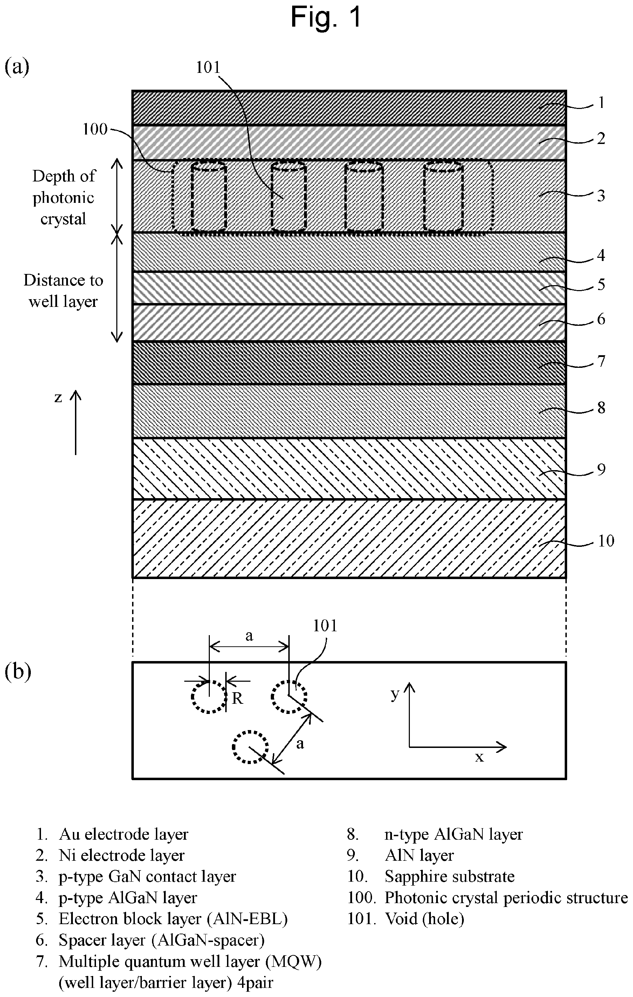

As the UVC-LED according to a first embodiment of the present invention, the structure (cross-sectional view and plan view) of the UVC-LED having the light emission wavelength λ of 230 nm is shown in Figs. 1. Fig. 1(a) is a cross-sectional view and Fig. 1(b) is a plan view as viewed from a lower side on the paper plane of Fig. 1(a).

An xyz Cartesian coordinate system is defined as a coordinate system for explanation. The stacking direction in Fig. 1(a), that is, the vertical direction on the paper plane is assumed to be a z direction, and in particular, the upward direction on the paper plane is assumed to be a +z direction and the downward direction on the paper plane is assumed to be a -z direction. The cross section is assumed to be parallel to an xy plane.

Specifically, in the cross-sectional view of Fig. 1(a), the UVC-LED includes an Au electrode layer 1, a Ni electrode layer 2, a p-type GaN contact layer 3, a p-type AlGaN layer 4, an electron block layer 5 (AlN-EBL), a spacer layer 6 (AlGaN-spacer), a multiple quantum well layer 7 (MQW), an n-type AlGaN layer 8, an AlN layer 9, and a sapphire substrate 10, in this order from a side opposite to the sapphire substrate 10 (i.e., from the +z side toward the -z side).

The p-type AlGaN layer 4, the electron block layer 5, the spacer layer 6, the multiple quantum well layer 7, and the n-type AlGaN layer 8 are transparent to the wavelength λ.

The Au electrode layer 1 and the Ni electrode layer 2 are p-electrode layers. An n-electrode layer is formed in the n-type AlGaN layer 8, but is not shown in Figs. 1.

The UVC-LED includes, in the thickness direction, a photonic crystal periodic structure that reflects light having the light emission wavelength λ. Hereinafter, the "photonic crystal" is occasionally abbreviated as a PhC. It is preferable that λ be set to, for example, 230 nm, but may be in a 230 nm band, in a range of 220 nm to 230 nm, in a range of 220 nm to 280 nm, or in the deep ultraviolet range.

As shown in the xy plane view of Fig. 1(b), a photonic crystal periodic structure 100 has a structure in which a plurality of cylindrical voids 101 (holes), each having a circular cross section with a radius R, is formed in a regular triangular lattice pattern with a period a in the xy plane. The radius R of the void 101 satisfies $0.35 \leq R/a$.

In the photonic crystal periodic structure 100, the plurality of voids 101 is formed so as to extend in a direction (z direction) toward the substrate in a partial or an entire area in the thickness direction (z direction) from a lower part (i.e., a lower part of the p-type electrode layer) of the Ni electrode layer 2 to an interface between the p-type GaN contact layer 3 and the p-type AlGaN layer 4.

With the radius R and the period a of the voids 101 constituting the photonic crystal periodic structure 100, a filling factor f of the aforementioned photonic crystal is calculated as:

$$f = 2\pi/3^{0.5} \times (R/a)^2 \ \dots \ (Equation\ 1).$$

Further, when the light emission wavelength is λ, the period a of the photonic crystal periodic structure satisfies the Bragg condition with respect to light having the light emission wavelength λ. That is, the following is satisfied:

$$m \times \lambda/n_{PhC} \ = \ 2a \ \dots \ (Equation\ 2).$$

In other words, $a = (m/2) \times \lambda/n_{PhC}$, where $n_{PhC}$ is an effective refractive index of the photonic crystal periodic structure, a is the period, and m is the order. The order m satisfies $m \leq 4$.

Here, when the refractive indices of two media that constitute the photonic crystal periodic structure are $n_1$ and $n_2$, the following is obtained:

$$n_{PhC} = (n_2{}^2 + (n_1{}^2 - n_2{}^2) \times f)^{0.5} \ \dots \ (Equation\ 3).$$

The photonic crystal periodic structure 100 has a photonic band gap that is open to a TE polarized light component.

The light having the wavelength λ emitted from the multiple quantum well layer 7 propagates through the media while being elliptically polarized, as TE light and TM light are radiated in all directions.

The distance between a quantum well layer (the quantum well layer most adjacent to the spacer layer 6) adjacent to the spacer layer 6 among the quantum well layers constituting the multiple quantum well layer 7 and the bottom part (bottom surface) of the photonic crystal periodic structure 100 satisfies a resonance condition λ/n of free end reflection. That is, the distance between the upper part (upper surface) of the quantum well layer and the bottom part of the photonic crystal periodic structure 100 substantially satisfies the resonance condition λ/n of free-end reflection. For example, the distance between the upper part of the quantum well layer and the bottom part of the photonic crystal periodic structure 100 falls within a range of (λ/n) ± 5 nm.

Here, n is a weighted average refractive index of the spacer layer 6, the electron block layer 5, and the p-type AlGaN layer 4. That is, n is a weighted average refractive index of the layer structure existing between the upper part of the quantum well layer and the bottom part of the photonic crystal periodic structure.

Thus, the light is reflected by the photonic crystal periodic structure 100 in a direction toward the sapphire substrate 10.

Here, the resonance condition λ/n is calculated as follows. Table 1 below shows the film thickness, the Al composition, and the refractive index of the p-type GaN contact layer 3, the p-type AlGaN layer 4, the electron block layer 5, and the spacer layer 6.

[Table 1]

| | Film thickness | Al composition | Refractive index |
|---|---|---|---|
| P-type GaN contact layer | 100 nm | - | 2.804 |
| P-type AlGaN layer | 65 nm | 0.90 | 2.647 |
| Electron block layer (AlN-EBL) | 9 nm | 1.0 | 2.505 |
| AlGaN spacer layer | 6 nm | 0.94→0.82 | 2.649 |

The resonance condition λ/n is calculated based on Table 1 above as follows:

λ/n = 230 nm/(2.649 * 6 nm + 2.505 * 9 nm + 2.647 * 65 nm)/(6 nm + 9 nm + 65 m) = 87.4 ≈ 87 nm.

Note that the refractive index of the spacer layer 6 was calculated using the weighted average refractive index, since the Al composition was changed from 0.94 to 0.82 depending on the position in the z direction.
With such a configuration, the light having the wavelength λ emitted from the multiple quantum well layer 7 is reflected by the photonic crystal periodic structure 100 in the direction toward the sapphire substrate 10, so that the light extraction efficiency (LEE) of the UVC-LED is improved.

[Example]

The following example includes an example of a method for manufacturing the aforementioned UVC-LED. Table 2 below shows the thickness of each layer in Fig. 1. Note that in the following description, "um" stands for micrometer.

[Table 2]

| | | Film thickness (thickness) |
|---|---|---|
| P-type GaN contact layer | | 100 nm |
| P-type AlGaN layer | | 45 nm-115 nm |
| Electron block layer (AlN-EBL) | | 9 nm |
| Spacer layer (AlGaN spacer) | | 6 nm |
| Multiple quantum well layer (MQW) | Quantum well layer × 4 | 3.5 nm |
| | Barrier layer × 4 | 1 nm |
| N-type AlGaN layer | | 1.5 um |
| AlN layer | | 4 um |
| Sapphire substrate | | 430 um |

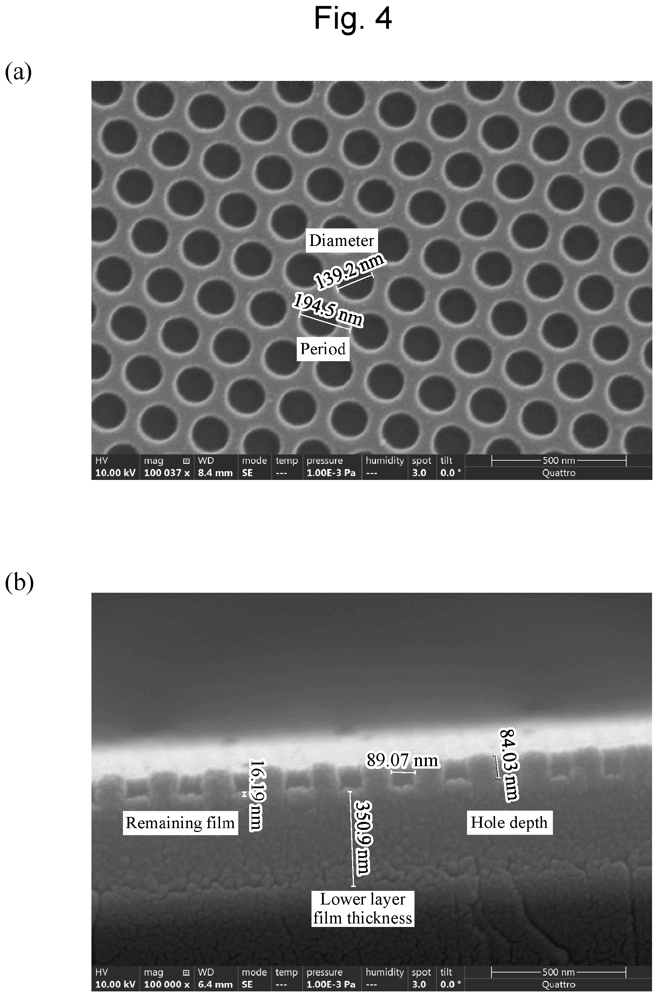

First, as shown in Table 2, crystal growth was sequentially performed on a 4 um-thick AlN layer, a 1.5 um-thick n-type AlGaN layer, a 18 nm-thick multiple quantum well layer (breakdown: alternately performed four times on 1 nm-thick barrier layer and 3.5 nm-thick quantum well layer), a 6 nm-thick spacer layer, a 9 nm-thick electron block layer, a p-type AlGaN layer, and a p-type GaN contact layer, on a 2-inch sapphire substrate having a thickness of 430 um. In this manner, a stacked structure was formed. Note that as for the p-type AlGaN layer, the film thickness was changed in increments of 10 nm within a range of 45 nm to 115 nm, and the p-type AlGaN layers in eight different types of thicknesses were used.

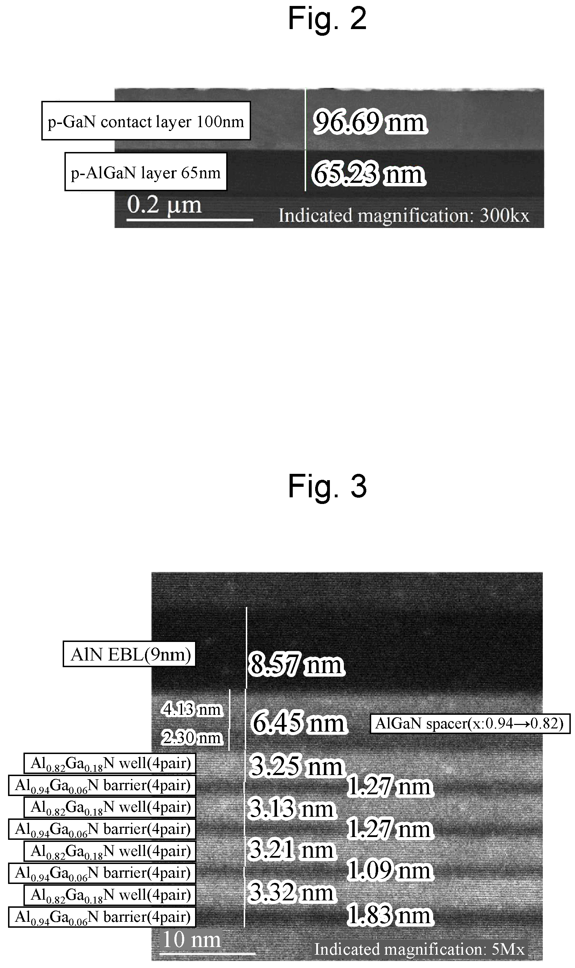

Fig. 2 shows a STEM cross-sectional image (STEM: scanning transmission electron microscope) of the p-type GaN contact layer/p-type AlGaN layer (having a film thickness of 65 nm as a typical example), and Fig. 3 shows a STEM cross-sectional image of the multiple quantum well layer/spacer layer (AlGaN-spacer)/electron block layer (AlN-EBL).
Next, a lower layer and an upper layer of a two-layer resist were sequentially spin-coated on the surface of the p-type GaN contact layer/p-type AlGaN layer (eight types of structure having the p-type AlGaN with different film thicknesses) shown in Fig. 2, and a pattern was transferred by a nanoimprint method using a resin mold having a pattern arranged in a regular triangular lattice with a diameter of 139 nm and a period of 199 nm. Fig. 4(a) shows a SEM top-view, and Fig. 4(b) shows a SEM cross-sectional image.
Thus, the method for manufacturing the UVC-LED includes a step of forming a pattern of a PhC periodic structure, in a two-layer resist composed of an upper layer and a lower layer using nanoimprint lithography.

Next, the pattern was processed using an ICP dry etching method. The structure of the PhC was of two types with a depth of 95 nm in which etching terminates within the p-type GaN contact layer (a film thickness of 100 nm) and with a depth of 100 nm in which etching terminates at the interface between the p-type GaN contact layer and the p-type AlGaN layer. Hereinafter, the structures in which the PhC with a depth of 95 nm and the PhC with a depth of 100 nm are used are occasionally abbreviated as "95 nm-PhC" and "100 nm-PhC," respectively. Similarly, a reference structure with no-PhC formed therein is occasionally abbreviated as "no-PhC."

In this manner, the method for manufacturing the UVC-LED includes the step of forming the PhC periodic structure, in the p-type GaN contact layer by ICP dry etching.

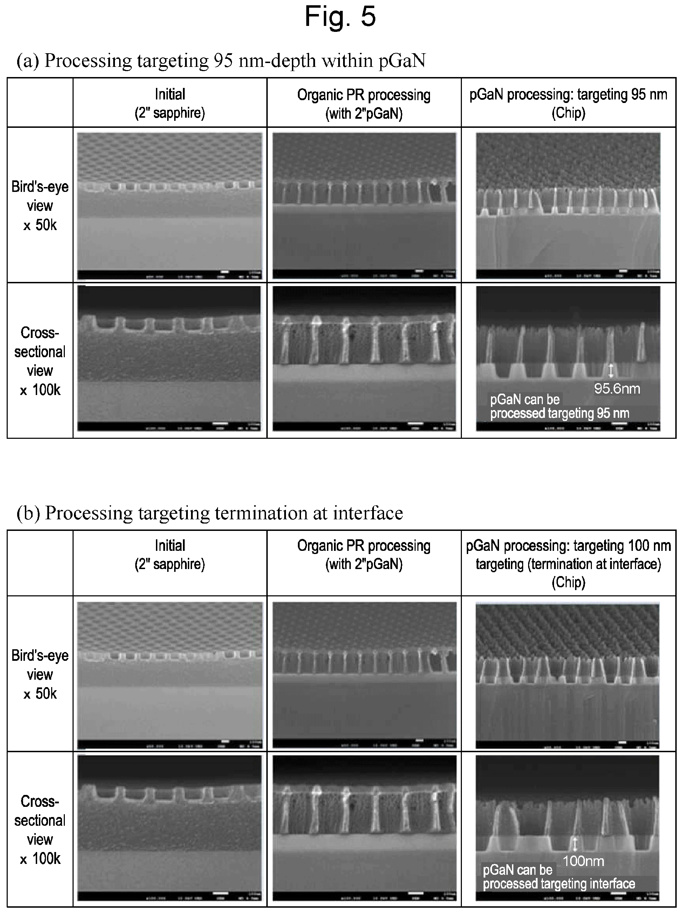

Figs. 5 show the SEM cross-sectional images (SEM: scanning electron microscope). Fig. 5(a) is an example of the 95 nm-PhC, and Fig. 5(b) is an example of the 100 nm-PhC. In Figs. 5(a) and 5(b), a bird's-eye view (× 50,000 magnification) including a cross section is on the upper side and the cross-sectional view (× 100,000 magnification) is on the lower side. The left column shows the state before processing, the middle column shows the state after a two-layer resist was formed using an organic photoresist, and the right column shows the state after ICP dry etching.

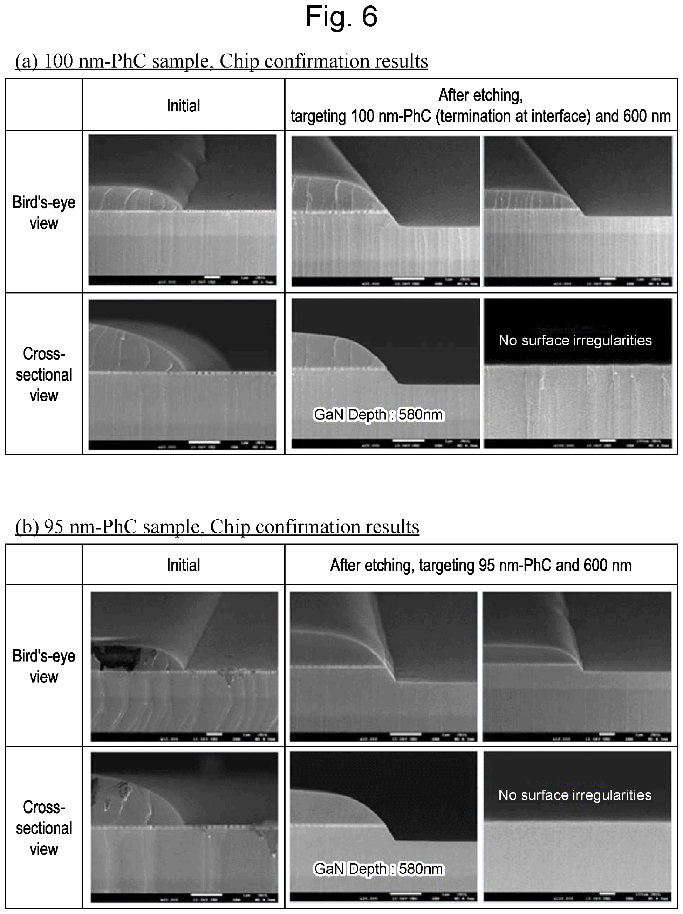

Next, p-mesa photolithography for electrode processing was performed on the sapphire substrate for the no-PhC, the 95 nm-PhC, and the 100 nm-PhC, and p-mesa processing was performed by ICP dry etching. Figs. 6 show the SEM cross-sectional images.

Fig. 6(a) is an example of the 100 nm-PhC and Fig. 6(b) is an example of the 95 nm-PhC. Note that the no-PhC is not shown. In Figs. 6(a) and 6(b), a bird's-eye view including a cross section is on the upper side and the cross-sectional view is on the lower side. The left column shows the state before dry etching and the middle and right columns show the state after dry etching. In particular, the state of an exposed surface of the n-type AlGaN layer is shown in the lower right column.

The n-type AlGaN layer on the n-electrode side was exposed, with a 600 nm-deep p-mesa. That is, in a partial region of the stacked structure, the p-type GaN contact layer, the p-type AlGaN layer, the electron block layer, the spacer layer, and the multiple quantum well layer were removed, and further, a part of the n-type AlGaN layer was removed, so that a part of the n-type AlGaN layer was exposed in the corresponding region. As a result, the region (p-electrode part) where the layers such as the p-type GaN contact layer remain unremoved and the region (n-electrode part) where the layers are partially removed to thus expose the n-type AlGaN layer are separated from each other.

As described above, the method for manufacturing the UVC-LED includes the step of separating the p-electrode part and the n-electrode part by p-mesa processing to expose a part of the n-type AlGaN layer. Note that the "p-electrode part" refers to a region where the layers such as the p-type GaN contact layer remain unremoved and where a p-electrode is formed in a subsequent step. Similarly, the "n-electrode part" refers to a region where the n-type AlGaN layer is exposed and where an n-electrode is formed in a subsequent step. However, upon completion of the step, the areas of the p-electrode part and the n-electrode part do not need to be clearly defined, and by exposing a part of the n-type AlGaN layer by p-mesa processing, the p-electrode part and the n-electrode part can be formed afterwards in accordance with the exposed region.

Next, the sapphire substrate was subjected to photolithography for an n-type electrode, development, and buffered hydrofluoric acid (BHF) treatment. Subsequently, V (15 nm thick)/Al (90 nm thick)/Ti (20 nm thick)/Au (30 nm thick) were deposited on the n-type AlGaN layer using an electron beam (EB) evaporation system, and then, a lift-off process (not shown) was performed. In this manner, the n-electrode was formed.

As described above, the method for manufacturing the UVC-LED includes the step of forming the n-electrode by evaporating vanadium (V), aluminum (Al), titanium (Ti), and gold (Au) on the surface of the exposed part of the n-type AlGaN layer.

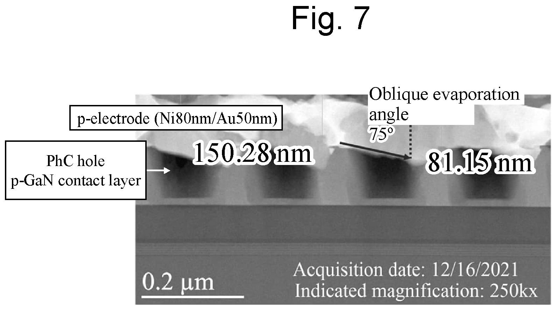

Then, the stacked structure was subjected to photolithography for a p-type electrode, development, and BHF treatment. Subsequently, to form both the electrodes of Ni (80 nm thick)/Au (50 nm thick), oblique evaporation was performed at an angle of 75° so as to prevent metal from entering the PhC holes formed in the p-type GaN contact layer. However, for the no-PhC, Ni (10 nm thick)/Au (100 nm thick) were evaporated vertically (angle 0°). Then, after the lift-off process, the three types of substrates were subjected to contact annealing by being held and heated at 550°C for 10 minutes in an Ar gas atmosphere. In this manner, the p-electrode was formed. Fig. 7 shows a STEM cross-sectional image of a reference structure that was subjected to oblique evaporation. Also in the present embodiment, oblique evaporation can be performed in the same manner as in the structure shown in Fig. 7.

As described above, the method for manufacturing the UVC-LED includes the step of forming the p-electrode by obliquely evaporating nickel (Ni) and gold (Au) on the surface of the p-type GaN contact layer (i.e., on the surface of the PhC periodic structure).

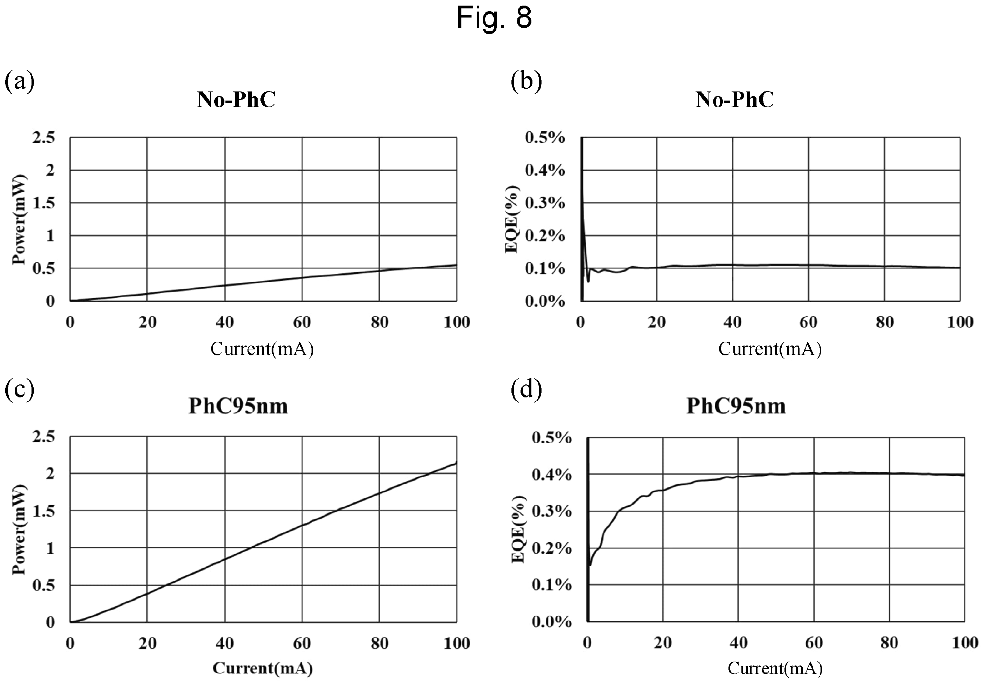

For each UVC-LED manufactured as described above, the current-power characteristics and the current-external quantum efficiency (EQE) characteristics were measured. The measurement was conducted particularly for the p-type AlGaN layers having different thicknesses and for the no-PhC, the 95 nm-PhC, and the 100 nm-PhC. As typical examples, Figs. 8 show the characteristics of the no-PhC and the 95 nm-PhC when the film thickness of the p-type AlGaN was 65 nm. Fig. 8(a) shows the current-output characteristics of the no-PhC, Fig. 8(b) shows the current-EQE characteristics of the no-PhC, Fig. 8(c) shows the current-output characteristics of the 95 nm-PhC, and Fig. 8(d) shows the current-EQE characteristics of the 95 nm-PhC. Compared with the no-PhC, the 95 nm-PhC exhibits a 3.9-fold enhancement effect in both the power and EQE.

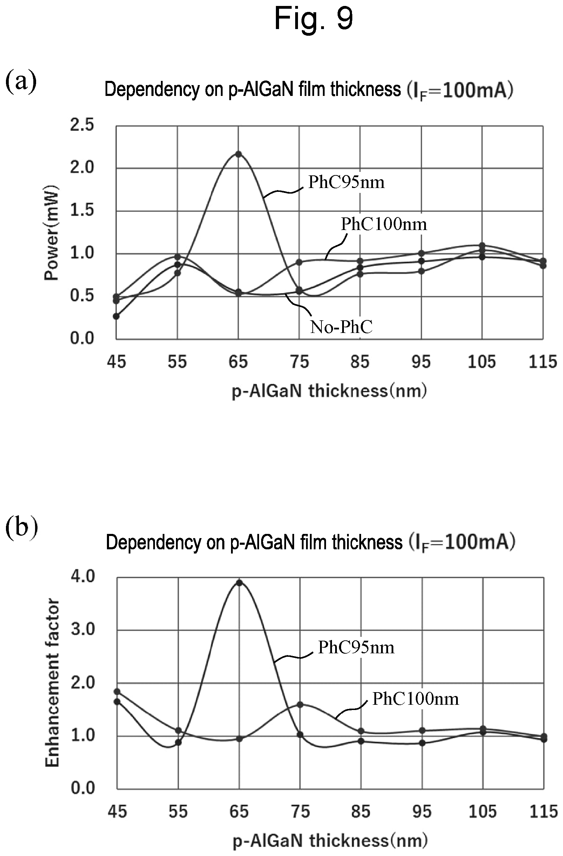

Now, Fig. 9 shows dependency on the p-type AlGaN film thickness of each UVC-LED. In Fig. 9(a), the horizontal axis represents the p-type AlGaN film thickness and the vertical axis represents the output (power) of the no-PhC, the 95 nm-PhC, and the 100 nm-PhC at a drive current ($I_F$) of 100 mA. In Fig. 9(b), the horizontal axis represents the p-type AlGaN film thickness and the vertical axis represents the enhancement factor of the 95 nm-PhC and the 100 nm-PhC. Here, the enhancement factor is a value obtained by dividing the output of the 95 nm-PhC and the 100 nm-PhC by the output of the no-PhC.

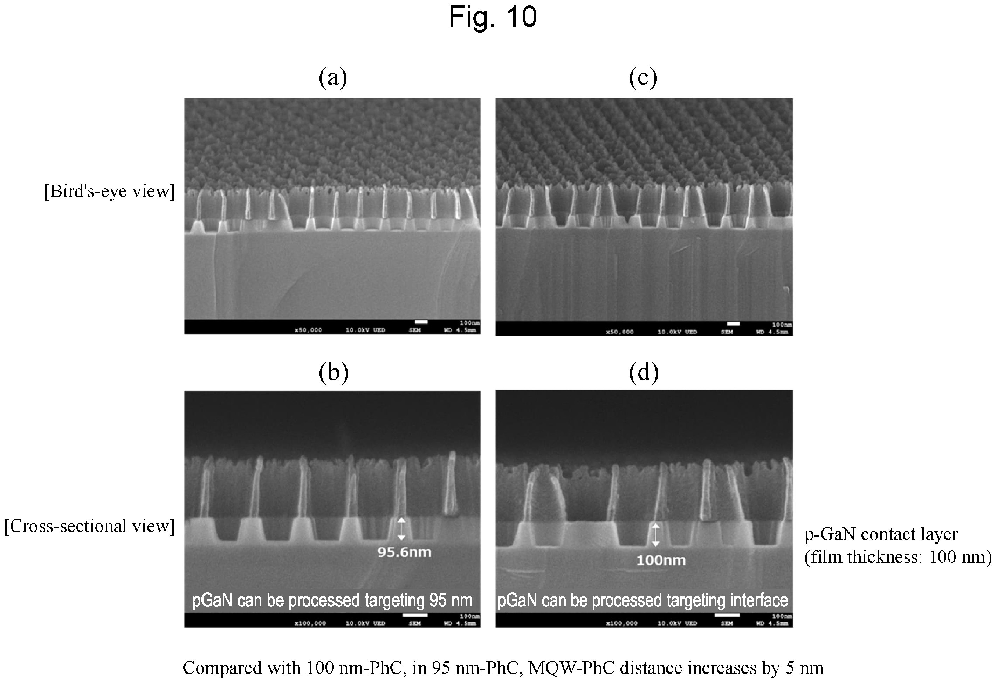

Next, Figs. 10 show SEM cross-sectional images of the 95 nm-PhC and the 100 nm-PhC formed in the p-type GaN contact layer as a reference structure analogous to the structure of the present embodiment. Fig. 10(a) is a bird's-eye view including a cross section of the 95 nm-PhC, Fig. 10(b) is an enlarged cross-sectional view of the 95 nm-PhC, Fig. 10(c) is a bird's-eye view including a cross section of the 100 nm-PhC, and Fig. 10(d) is an enlarged cross-sectional view of the 100 nm-PhC.

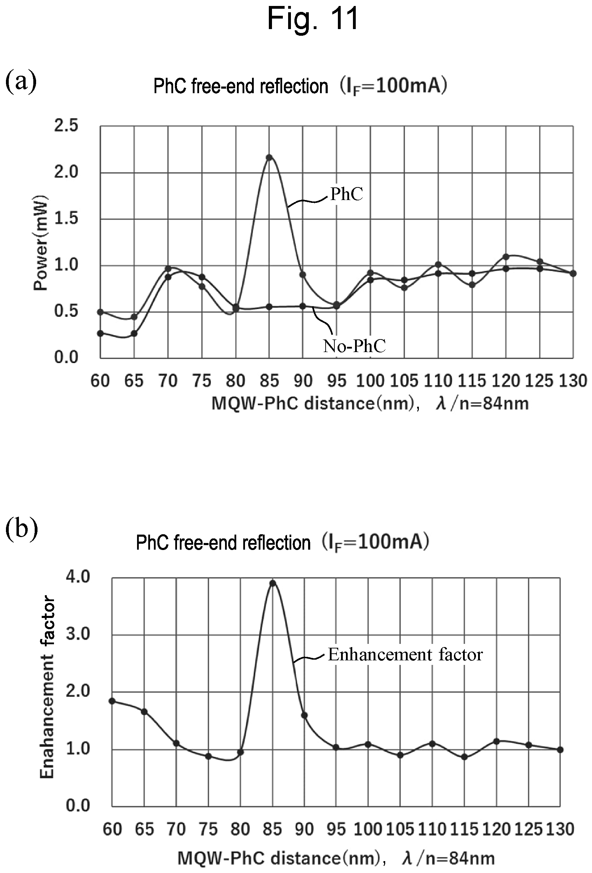

Here, when the distance between the multiple quantum well layer and the PhC is focused, it is confirmed from the drawing that the 95 nm-PhC is larger than the PhC of 100-nm by 5 nm. Therefore, when the horizontal axis of each graph in Figs. 9 is changed to the distance between the multiple quantum well layer and the PhC and the vertical axis represents the output and enhancement factor, the graphs in Fig. 11 are obtained.

Here, as described in relation to Figs. 9, when the distance between the **multiple** quantum well layer and the PhC is equal to 85 nm where the 3.9-fold enhancement factor as the maximum value is exhibited, the bottom part of the PhC is located exactly 5 nm above the interface between the p-GaN contact layer and the p-AlGaN layer. **In** that case, the distance that satisfies the resonance condition is calculated, using the refractive index of the p-GaN contact layer in Table 1, as 230 nm/(2.649 * 6 + 2.505 * 9 + 2.647 * 65 + 2.804 * 5)/(6 + 9 + 65 + 5) = 87.08 ≈ 87 nm. The distance substantially matches the resonance condition of $\lambda/n$ = 87 nm, and as a result, a specific photosensitizing effect was obtained. This phenomenon indicates the free-end reflection in the PhC in which there is no phase difference between the incident waves and the reflected waves.

**In** the above-described embodiment, the configurations and the like shown in the accompanying drawings are not restrictive, and can be modified as appropriate within the scope in which the advantageous effects of the present invention are exhibited. **In** addition, any appropriate modifications are possible without departing from the scope of the object of the present invention. Further, the components of the present invention can be optionally selected, and inventions that include the selected components are also encompassed by the present invention.

Industrial Applicability

The present invention is applicable to deep ultraviolet LEDs.

Reference Signs List

| | |
|---|---|
| 1 | Au electrode layer |
| 2 | Ni electrode layer |
| 3 | p-type GaN contact layer |
| 4 | p-type AlGaN layer |
| 5 | electron block layer |
| 6 | spacer layer |
| 7 | multiple quantum well layer |
| 8 | n-type AlGaN layer |
| 9 | AlN layer |
| 10 | sapphire substrate |
| 100 | photonic crystal periodic structure |
| 101 | void (hole) |

**Claims**

1. An AlGaN-based deep ultraviolet LED having a wavelength $\lambda$ of emission light, the AlGaN-based deep ultraviolet LED comprising a photonic crystal periodic structure in a thickness direction,
   wherein a distance between an upper part of a quantum well layer and a bottom part of the photonic crystal periodic structure substantially satisfies a resonance condition $\lambda/n$ of free-end reflection, wherein n is a weighted average refractive index of a layer structure existing between the upper part of the quantum well layer and the bottom part of the photonic crystal periodic structure.

2. The AlGaN-based deep ultraviolet LED according to claim 1, wherein a period a of the photonic crystal periodic structure relative to light having the wavelength $\lambda$ satisfies a Bragg condition of $a = (m/2) \times \lambda/n_{Phc}$, wherein $m \leq 4$ and $n_{Phc}$ is an effective refractive index of the photonic crystal periodic structure.

3. The AlGaN-based deep ultraviolet LED according to claim 1, wherein the photonic crystal periodic structure comprises a plurality of holes formed in an area in a thickness direction from a lower part of a p-type electrode layer to an interface between a p-type GaN contact layer and a p-type AlGaN layer.

4. The AlGaN deep ultraviolet LED according to claim 3, wherein when a radius of each of the holes is R and a period of the photonic crystal periodic structure is a, $0.35 \leq R/a$ is satisfied.

5. The AlGaN-based deep ultraviolet LED according to claim 1, wherein the photonic crystal periodic structure comprises a photonic band gap that is open to a TE polarized light component.

6. The AlGaN-based deep ultraviolet LED according to claim 1, comprising, sequentially from a side opposite to a substrate:

   an Au electrode layer;
   a Ni electrode layer;
   a p-type GaN contact layer;
   a p-type AlGaN layer transparent to the wavelength $\lambda$;
   an electron block layer transparent to the wavelength $\lambda$;
   a spacer layer transparent to the wavelength $\lambda$;
   a multiple quantum well layer transparent to the wavelength $\lambda$; and
   an n-type AlGaN layer transparent to the wavelength $\lambda$.

7. The AlGaN-based deep ultraviolet LED according to claim 1, wherein the distance between the upper part of the quantum well layer and the bottom part of the photonic crystal periodic structure falls within a range of $(\lambda/n) \pm 5$ nm.

8. A method for manufacturing the AlGaN-based deep ultraviolet LED according to claim 6, the method comprising:

   forming a pattern of the photonic crystal periodic structure, in a two-layer resist composed of an upper layer and a lower layer using nanoimprint lithography;
   forming the photonic crystal periodic structure, in the p-type GaN contact layer by ICP dry etching;
   separating an n-electrode part and a p-electrode part by p-mesa processing to expose a part of the n-type AlGaN layer;
   forming an n-electrode by evaporating vanadium (V), aluminum (Al), titanium (Ti), and gold (Au) on a surface of the exposed part of the n-type AlGaN layer; and
   forming a p-electrode by obliquely evaporating nickel (Ni) and gold (Au) on a surface of the p-type GaN contact layer.

# Fig. 1

(a)

(b)

1. Au electrode layer
2. Ni electrode layer
3. p-type GaN contact layer
4. p-type AlGaN layer
5. Electron block layer (AlN-EBL)
6. Spacer layer (AlGaN-spacer)
7. Multiple quantum well layer (MQW) (well layer/barrier layer) 4pair

8. n-type AlGaN layer
9. AlN layer
10. Sapphire substrate
100. Photonic crystal periodic structure
101. Void (hole)

# Fig. 2

p-GaN contact layer 100nm — 96.69 nm

p-AlGaN layer 65nm — 65.23 nm

0.2 μm

Indicated magnification: 300kx

# Fig. 3

AlN EBL(9nm) — 8.57 nm

4.13 nm

2.30 nm — 6.45 nm — AlGaN spacer(x:0.94→0.82)

$Al_{0.82}Ga_{0.18}N$ well(4pair) — 3.25 nm — 1.27 nm

$Al_{0.94}Ga_{0.06}N$ barrier(4pair)

$Al_{0.82}Ga_{0.18}N$ well(4pair) — 3.13 nm — 1.27 nm

$Al_{0.94}Ga_{0.06}N$ barrier(4pair)

$Al_{0.82}Ga_{0.18}N$ well(4pair) — 3.21 nm — 1.09 nm

$Al_{0.94}Ga_{0.06}N$ barrier(4pair)

$Al_{0.82}Ga_{0.18}N$ well(4pair) — 3.32 nm — 1.83 nm

$Al_{0.94}Ga_{0.06}N$ barrier(4pair)

10 nm

Indicated magnification: 5Mx

# Fig. 4

(a)

(b)

# Fig. 5

## (a) Processing targeting 95 nm-depth within pGaN

| | Initial (2" sapphire) | Organic PR processing (with 2"pGaN) | pGaN processing: targeting 95 nm (Chip) |
|---|---|---|---|
| Bird's-eye view x 50k | | | |
| Cross-sectional view x 100k | | | 95.6nm pGaN can be processed targeting 95 nm |

## (b) Processing targeting termination at interface

| | Initial (2" sapphire) | Organic PR processing (with 2"pGaN) | pGaN processing: targeting 100 nm targeting (termination at interface) (Chip) |
|---|---|---|---|
| Bird's-eye view x 50k | | | |
| Cross-sectional view x 100k | | | 100nm pGaN can be processed targeting interface |

# Fig. 6

(a) 100 nm-PhC sample, Chip confirmation results

| | Initial | After etching, targeting 100 nm-PhC (termination at interface) and 600 nm | |
|---|---|---|---|
| Bird's-eye view | | | |
| Cross-sectional view | | GaN Depth : 580nm | No surface irregularities |

(b) 95 nm-PhC sample, Chip confirmation results

| | Initial | After etching, targeting 95 nm-PhC and 600 nm | |
|---|---|---|---|
| Bird's-eye view | | | |
| Cross-sectional view | | GaN Depth : 580nm | No surface irregularities |

# Fig. 7

# Fig. 8

(a)

**No-PhC**

(b)

**No-PhC**

(c)

**PhC95nm**

(d)

**PhC95nm**

EP 4 780 173 A1

# Fig. 9

(a)

Dependency on p-AlGaN film thickness ($I_F$=100mA)

PhC95nm

PhC100nm

No-PhC

(b)

Dependency on p-AlGaN film thickness ($I_F$=100mA)

PhC95nm

PhC100nm

# Fig. 10

EP 4 780 173 A1

[Bird's-eye view]

(a)

(c)

[Cross-sectional view]

(b)

**95.6nm**

pGaN can be processed targeting 95 nm

(d)

**100nm**

pGaN can be processed targeting interface

p-GaN contact layer
(film thickness: 100 nm)

Compared with 100 nm-PhC, in 95 nm-PhC, MQW-PhC distance increases by 5 nm

# Fig. 11

(a)

PhC free-end reflection （I$_F$=100mA）

(b)

PhC free-end reflection （I$_F$=100mA）

## INTERNATIONAL SEARCH REPORT

| International application No. |
|---|
| **PCT/JP2024/032720** |

### A. CLASSIFICATION OF SUBJECT MATTER

*H01L 33/10*(2010.01)i; *H01L 33/32*(2010.01)i
FI:   H01L33/10; H01L33/32

According to International Patent Classification (IPC) or to both national classification and IPC

### B. FIELDS SEARCHED

Minimum documentation searched (classification system followed by classification symbols)

H01L33/00-33/64; H01S5/00-5/50

Documentation searched other than minimum documentation to the extent that such documents are included in the fields searched

Published examined utility model applications of Japan 1922-1996
Published unexamined utility model applications of Japan 1971-2024
Registered utility model specifications of Japan 1996-2024
Published registered utility model applications of Japan 1994-2024

Electronic data base consulted during the international search (name of data base and, where practicable, search terms used)

### C. DOCUMENTS CONSIDERED TO BE RELEVANT

| Category* | Citation of document, with indication, where appropriate, of the relevant passages | Relevant to claim No. |
|---|---|---|
| X | WO 2019/146737 A1 (MARUBUN CORPORATION) 01 August 2019 (2019-08-01) paragraphs [0005]-[0019], [0022]-[0047], [0117]-[0123], fig. 1-8, 26 | 1-7 |
| Y | | 8 |
| Y | JP 2009-59970 A (SEIWA ELECTRIC MFG. CO., LTD.) 19 March 2009 (2009-03-19) paragraphs [0035]-[0061], fig. 1-7 | 8 |
| Y | JP 2006-173534 A (TOYODA GOSEI CO., LTD.) 29 June 2006 (2006-06-29) paragraphs [0008]-[0028], fig. 1-3 | 8 |
| A | WO 2020/138146 A1 (MARUBUN CORPORATION) 02 July 2020 (2020-07-02) entire text, all drawings | 1-8 |
| A | EP 3993070 A1 (SUZHOU UVCANTEK CO., LTD.) 04 May 2022 (2022-05-04) entire text, all drawings | 1-8 |

☐ Further documents are listed in the continuation of Box C.      ☑ See patent family annex.

| * | Special categories of cited documents: |
|---|---|
| "A" | document defining the general state of the art which is not considered to be of particular relevance |
| "D" | document cited by the applicant in the international application |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

| "T" | later document published after the international filing date or priority date and not in conflict with the application but cited to understand the principle or theory underlying the invention |
|---|---|
| "X" | document of particular relevance; the claimed invention cannot be considered novel or cannot be considered to involve an inventive step when the document is taken alone |
| "Y" | document of particular relevance; the claimed invention cannot be considered to involve an inventive step when the document is combined with one or more other such documents, such combination being obvious to a person skilled in the art |
| "&" | document member of the same patent family |

| Date of the actual completion of the international search | Date of mailing of the international search report |
|---|---|
| **07 October 2024** | **15 October 2024** |

| Name and mailing address of the ISA/JP | Authorized officer |
|---|---|
| **Japan Patent Office (ISA/JP)** **3-4-3 Kasumigaseki, Chiyoda-ku, Tokyo 100-8915 Japan** | |
| | Telephone No. |

Form PCT/ISA/210 (second sheet) (July 2022)

**INTERNATIONAL SEARCH REPORT**
Information on patent family members

International application No.

**PCT/JP2024/032720**

| Patent document cited in search report | | | Publication date (day/month/year) | Patent family member(s) | | | Publication date (day/month/year) |
|---|---|---|---|---|---|---|---|
| WO | 2019/146737 | A1 | 01 August 2019 | US | 2021/0036186 | A1 | |
| | | | | paragraphs [0002]-[0019], [0052]-[0074], [0139]-[0146], fig. 1-8, 26 | | | |
| JP | 2009-59970 | A | 19 March 2009 | (Family: none) | | | |
| JP | 2006-173534 | A | 29 June 2006 | (Family: none) | | | |
| WO | 2020/138146 | A1 | 02 July 2020 | TW | 202032811 | A | |
| | | | | JP | 2020-107778 | A | |
| EP | 3993070 | A1 | 04 May 2022 | WO | 2021/189763 | A1 | |
| | | | | CN | 111312877 | A | |

Form PCT/ISA/210 (patent family annex) (July 2022)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 6156898 B

**Non-patent literature cited in the description**

- *Applied Physics Express*, 2021, vol. 14, 084004